# EUROPEAN PATENT APPLICATION

(11) **EP 1 930 910 A1**
(43) Date of publication of application: **11.06.2008**
(21) Application number: 07023603.9
(22) Date of filing: 05.12.2007
(51) Int. Cl.: G11C 16/02, G11C 16/12, G11C 16/30, G11C 5/14

(54) **Memory that limits power consumption**

(30) Priority: 07.12.2006 US 635194
(71) Applicant: Qimonda North America Corp., Cary, NC 27513 (US)
(72) Inventor: Philipp, Jan Boris, 81673 München (DE); Nirschl, Thomas, 81739 München (DE)
(74) Representative: Jehle, Volker Armin

(57) **Abstract**

One embodiment provides a memory including resistive memory cells, a pulse generator, and a circuit. Each of the resistive memory cells is programmable to each of at least two states. The pulse generator provides write pulses to program the resistive memory cells. The circuit receives a first current and limits the first current and provides stored charge in a second current to the pulse generator to program the resistive memory cells.

## Description

### Background

One type of memory is resistive memory. Resistive memory utilizes the resistance value of a memory element to store one or more bits of data. For example, a memory element programmed to have a high resistance value may represent a logic "1" and a memory element programmed to have a low resistance value may represent a logic "0". Typically, the resistance value of the memory element is switched electrically by applying a voltage pulse or a current pulse.

One type of resistive memory is phase change memory. Phase change memory uses a phase change material in the resistive memory element. The phase change material exhibits at least two different states, including states referred to as the amorphous state and the crystalline state. The amorphous state involves a more disordered atomic structure and the crystalline state involves a more ordered lattice. The amorphous state usually exhibits higher resistivity than the crystalline state. Also, some phase change materials exhibit multiple crystalline states, e.g. a face-centered cubic (FCC) state and a hexagonal closest packing (HCP) state, which have different resistivities and may be used to store data. In the following description, the amorphous state refers to the state having the higher resistivity and the crystalline state refers to the state having the lower resistivity.

Phase changes in the phase change materials may be induced reversibly. In this way, the memory may change from the amorphous state to the crystalline state and from the crystalline state to the amorphous state in response to temperature changes. The temperature changes to the phase change material may be achieved by driving current through the phase change material itself or by driving current through a resistive heater adjacent the phase change material. With both of these methods, controllable heating of the phase change material causes controllable phase change within the phase change material.

A phase change memory including an array of memory cells that are made of phase change material may be programmed to store data utilizing the memory states of the phase change material. One way to read and write data in such a phase change memory device is to control a current and/or a voltage pulse that is applied to the phase change material. The level of current and/or voltage generally corresponds to the temperature induced within the phase change material of a memory cell.

In some memories, a write circuit generates a current pulse for heating the phase-change material in the target phase change memory cell to program the phase change memory cell. The write circuit generates an appropriate current pulse, which is distributed to the target cell. The current pulse amplitude and the current pulse duration are controlled depending on the specific state to which the target cell is being programmed. Generally, a "set" operation of a memory cell is heating the phase-change material of the target cell above its crystallization temperature (but below its melting temperature) long enough to achieve the crystalline state. Generally, a "reset" operation of a memory cell is heating the phase-change material of the target cell above its melting temperature, and then quickly quench cooling the material, thereby achieving the amorphous state. A memory cell can be programmed to a resistance state between an amorphous state and a crystalline state by applying a partial "set" or a partial "reset" pulse to the memory cell to provide amorphous and crystalline fractions of the phase change material.

Typically, the amplitude of a reset current pulse is higher than the amplitude of a set current pulse and the duration of the reset current pulse is shorter than the duration of the set current pulse, where the duration of the reset current pulse is usually less than 100 nano-seconds. The peak current consumption of a phase change memory occurs as the write circuit resets phase change memory cells. This peak current consumption of a phase change memory may exceed current specifications of systems, such as random access memory systems and embedded memory systems. In embedded memory systems, the embedded system power supply may not be able to provide the current pulse amplitudes needed to reset the phase change memory cells.

For these and other reasons, there is a need for the present invention.

### Summary

The present invention provides a memory that limits peak power consumption. One embodiment provides a memory including resistive memory cells, a pulse generator, and a circuit. Each of the resistive memory cells is programmable to each of at least two states. The pulse generator provides write pulses to program the resistive memory cells. The circuit receives a first current and limits the first current and provides stored charge in a second current to the pulse generator to program the resistive memory cells.

### Brief Description of the Drawings

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
Figure 1 is a diagram illustrating one embodiment of an electronic system according to the present invention.
Figure 2 is a block diagram illustrating one embodiment of a memory.
Figure 3 is a diagram illustrating one embodiment of a write circuit and a power supply.
Figure 4 is a diagram illustrating one embodiment of a power supply and a write circuit that includes two switches.
Figure 5 is a diagram illustrating one embodiment of a power supply and a write circuit that includes a charge pump.
Figure 6 is a diagram illustrating one embodiment of a power supply and a write circuit that includes a three switch charge pump.

### Detailed Description

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

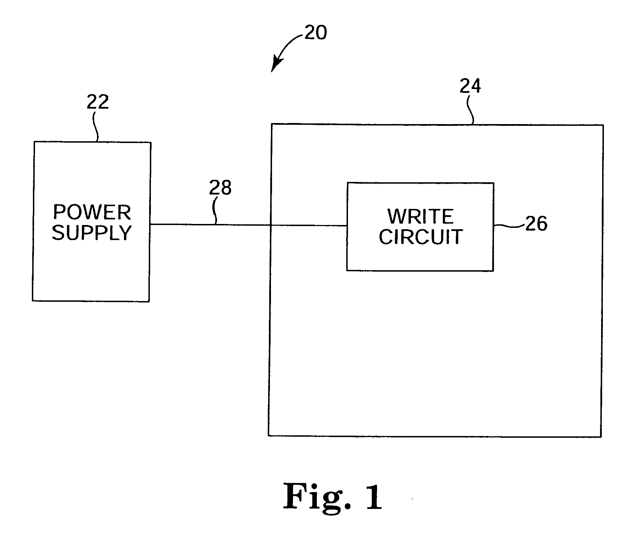

Figure 1 is a diagram illustrating one embodiment of an electronic system 20 according to the present invention. Electronic system 20 includes a power supply 22 and a phase change memory 24. In one embodiment, electronic system 20 is an embedded system. In one embodiment, power supply 22 is an embedded system power supply. In one embodiment, memory 24 is an embedded system phase change memory. In one embodiment, electronic system 20 is an embedded random access memory system.

As used herein, the term "electrically coupled" is not meant to mean that the elements must be directly coupled together and intervening elements may be provided between the "electrically coupled" elements.

Memory 24 includes phase change memory cells and a write circuit 26. Power supply 22 is electrically coupled to memory 24 and to write circuit 26 via power supply paths 28. Power supply 22 provides power, i.e., voltage and current, to memory 24 and to write circuit 26 via power supply paths 28. In one embodiment, memory 24 includes single bit phase change memory cells. In one embodiment, memory 24 includes multi-bit phase change memory cells.

Write circuit 26 receives power from power supply 22 and programs phase change memory cells. Write circuit 26 provides programming pulses to the phase change material in the phase change memory cells to program the phase change memory cells. Memory 24 consumes peak power while write circuit 26 programs phase change memory cells, such as while write circuit 26 provides a reset pulse to a phase change memory cell. Write circuit 26 limits the peak power consumption of memory 24 to stay within the limits of electronic system 20 and power supply 22. In one embodiment, write circuit 26 limits the peak power consumption of memory 24 to make it compatible with the requirements of an embedded random access memory system. In one embodiment, write circuit 26 limits the peak power consumption of memory 24 to make it compatible with an embedded system power supply. In other embodiments, write circuit 26 limits the peak power consumption to make it compatible with any suitable electronic system.

Write circuit 26 controls current and/or voltage programming pulse amplitudes and durations to program specific states into the phase change memory cells. The level of a programming pulse corresponds to the temperature induced within the phase change material of the phase change memory cell. Write circuit 26 provides one or more set pulses that heat the phase-change material of the target phase change memory cell above its crystallization temperature (but below its melting temperature) long enough to achieve the crystalline state. Write circuit 26 provides a reset pulse that heats the phase-change material of the target phase change memory cell above its melting temperature, and then quickly quench cools the material, thereby achieving the amorphous state. In multi-bit phase change memory embodiments, write circuit 26 programs a resistance state between the amorphous state and the crystalline state by applying a partial set or a partial reset operation to the phase change memory cell.

The peak current consumption and the peak power consumption of memory 24 occur while write circuit 26 resets one or more phase change memory cells. In other embodiments, the peak current consumption and the peak power consumption can occur while write circuit 26 provides any suitable programming pulse(s).

The amplitude of a reset pulse is higher than the amplitude of a set pulse, and the duration of the reset pulse is shorter than the duration of the set pulse. In one embodiment, the duration of the reset pulse is less than 100 nano-seconds. In one embodiment, the duration of the reset pulse is approximately 20 nano-seconds. In other embodiments, the duration of the reset pulse can be any suitable value.

In operation, write circuit 26 receives current from power supply 22. Memory 24 receives a write command and write circuit 26 is controlled to program one or more phase change memory cells. Write circuit 26 limits the current drawn from power supply 22 to stay within limits of electronic system 20 and power supply 22. Write circuit 26 completes programming the phase change memory cell while limiting the current drawn from power supply 22. In one embodiment, write circuit 26 receives current from power supply 22 as it completes programming the phase change memory cell. In other embodiments, write circuit 26 does not receive current from power supply 22 as it completes programming the phase change memory cell.

In one embodiment, write circuit 26 controls the amount of current drawn from power supply 22 via limiting the current supplied to a capacitor and a pulse generator. The capacitor is charged via current from power supply 22, and the current drawn from power supply 22 is limited while write circuit 26 programs one or more phase change memory cells. The capacitor supplies stored charge in a programming current to the pulse generator while write circuit 26 programs one or more phase change memory cells and limits the current drawn from power supply 22.

In one embodiment, write circuit 26 controls the amount of current drawn from power supply 22 via limiting the current provided to one side of a capacitor and a pulse generator, and by limiting return current from the pulse generator. The capacitor is charged via current from power supply 22. The current drawn from power supply 22 and the return current from the pulse generator are limited while write circuit 26 programs one or more phase change memory cells. The capacitor supplies stored charge in a programming current to the pulse generator while write circuit 26 programs one or more phase change memory cells and limits the current drawn from power supply 22 and the return current from the pulse generator.

In other embodiments, write circuit 26 limits the current drawn from power supply 22 via a charge pump. In one embodiment, write circuit 26 controls the amount of current drawn from power supply 22 via charging one side of a capacitor and then charging the other side of the capacitor to boost the voltage on the one side of the capacitor. The capacitor supplies stored charge in a programming current to the pulse generator to program one or more phase change memory cells.

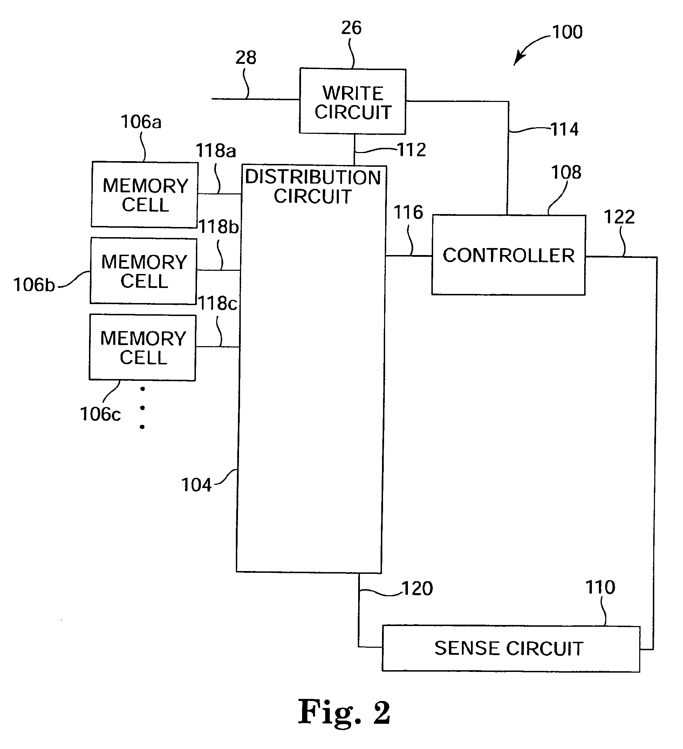

Figure 2 is a block diagram illustrating one embodiment of a memory 100 that is similar to phase change memory 24. Memory 100 includes write circuit 26, a distribution circuit 104, memory cells 106a, 106b, and 106c, a controller 108, and a sense circuit 110. In one embodiment, memory cells 106a-106c are phase change memory cells that store data based on the amorphous and crystalline states of phase change material in the memory cells. In another embodiment, memory cells 106a-106c are multi-level memory cells that can store more than one data bit.

Each of the memory cells 106a-106c can be written or programmed into one of two or more states by programming the phase change material to have intermediate resistance values. To program one of the memory cells 106a-106c to an intermediate resistance value, the amount of crystalline material coexisting with amorphous material and hence the cell resistance is controlled via controller 108 and a suitable write strategy. In one embodiment, each of the memory cells 106a-106c can be programmed into any one of three states. In one embodiment, each of the memory cells 106a-106c can be programmed into any one of four states. In other embodiments, each of the memory cells 106a-106c can be programmed into any one of any suitable number of states.

Write circuit 26 is electrically coupled to distribution circuit 104 via signal path 112 and to controller 108 via signal path 114. Write circuit 26 is electrically coupled to power supply 22 via power supply paths 28. Power supply 22 provides power to memory 100 and to write circuit 26 via power supply paths 28. Write circuit 26 receives power from power supply 22 and programs memory cells 106a-106c.

Controller 108 is electrically coupled to distribution circuit 104 via signal path 116. Controller 108 is also electrically coupled to sense circuit 110 via signal path 122. Sense circuit 110 is electrically coupled to distribution circuit 104 via signal path 120.

Distribution circuit 104 is electrically coupled to each of the memory cells 106a-106c via signal paths 118a-118c. Distribution circuit 104 is electrically coupled to memory cell 106a via signal path 118a. Distribution circuit 104 is electrically coupled to memory cell 106b via signal path 118b and distribution circuit 104 is electrically coupled to memory cell 106c via signal path 118c. In one embodiment, memory cells 106a-106c are part of an array of memory cells, where the array of memory cells includes any suitable number of memory cells.

Each of the memory cells 106a-106c includes a phase change material that may be changed from an amorphous state to a crystalline state or from a crystalline state to an amorphous state under the influence of temperature change. In one embodiment, the amount of crystalline phase change material coexisting with amorphous phase change material in one of the memory cells 106a-106c thereby defines the more than two states for storing data within the memory cell and memory 100.

The phase change material of memory cells 106a-106c may be made up of a variety of materials in accordance with the present invention. Generally, chalcogenide alloys that contain one or more elements from group VI of the periodic table are useful as such materials. In one embodiment, the phase change material is made up of a chalcogenide compound material, such as GeSbTe, SbTe, GeTe, or AgInSbTe. In another embodiment, the phase change material is chalcogen free, such as GeSb, GaSb, InSb, or GeGaInSb. In other embodiments, the phase change material is made up of any suitable material including one or more of the elements Ge, Sb, Te, Ga, As, In, Se, and S.

Controller 108 controls write circuit 26, sense circuit 110, and distribution circuit 104. Controller 108 includes a microprocessor, microcontroller, or other suitable circuitry for controlling write circuit 26, sense circuit 110, and distribution circuit 104. Controller 108 controls write circuit 26 and distribution circuit 104 for programming the resistance states of memory cells 106a-106c. Controller 108 controls sense circuit 110 and distribution circuit 104 for reading the resistance states of memory cells 106a-106c.

Write circuit 26 provides programming pulses to memory cells 106a-106c and programs resistance levels or states into the phase change material of each of the memory cells 106a-106c. In one embodiment, write circuit 26 provides voltage pulses to distribution circuit 104 through signal path 112 and distribution circuit 104 directs the voltage pulses to memory cells 106a-106c through signal paths 118a-118c. In one embodiment, distribution circuit 104 includes a plurality of transistors that controllably direct voltage pulses to each of the memory cells 106a-106c. In one embodiment, write circuit 26 provides current pulses to distribution circuit 104 through signal path 112 and distribution circuit 104 directs the current pulses to memory cells 106a-106c through signal paths 118a-118c. In one embodiment, distribution circuit 104 includes a plurality of transistors that controllably direct current pulses to each of the memory cells 106a-106c.

Write circuit 26 receives power from power supply 22 to program memory cells 106a-106c. Memory 100 consumes peak power while write circuit 26 programs memory cells 106a-106c, such as while write circuit 26 provides a reset pulse to one of the memory cells 106a-106c. Write circuit 26 limits peak power consumption of memory 100 to stay within the limits of electronic system 20 and power supply 22. In one embodiment, write circuit 26 limits peak power consumption of memory 100 to make it compatible with the requirements of an embedded random access memory system. In one embodiment, write circuit 26 limits peak power consumption of memory 100 to make it compatible with an embedded system power supply. In other embodiments, write circuit 26 limits peak power consumption of memory 100 to make it compatible with any suitable electronic system.

Write circuit 26 controls programming pulse (current pulse and/or voltage pulse) amplitudes and durations to program specific states into the memory cells 106a-106c. The level of a programming pulse corresponds to the temperature induced within the phase change material of the phase change memory cell. Write circuit 26 provides one or more set pulses that heat the phase-change material of the target phase change memory cell above its crystallization temperature (but below its melting temperature) long enough to achieve the crystalline state. Write circuit 26 provides a reset pulse that heats the phase-change material of the target phase change memory cell above its melting temperature, and then quickly quench cools the material, thereby achieving the amorphous state. In one embodiment, write circuit 26 programs a resistance state between the amorphous state and the crystalline state by applying a partial set or a partial reset to the phase change memory cell to provide amorphous and crystalline fractions of the phase change material.

The peak current consumption and the peak power consumption of memory 100 occur as write circuit 26 resets one or more of the memory cells 106a-106c. In other embodiments, the peak current consumption and the peak power consumption can occur as write circuit 26 provides any suitable programming pulse(s).

The amplitude of a reset pulse is higher than the amplitude of a set pulse, and the duration of the reset pulse is shorter than the duration of the set pulse. In one embodiment, the duration of the reset pulse is less than 100 nano-seconds. In one embodiment, the duration of the reset pulse is approximately 20 nano-seconds. In other embodiments, the duration of the reset pulse can be any suitable value.

Sense circuit 110 senses the resistance of phase change material and provides signals that indicate the resistive state of the phase change material in memory cells 106a-106c. Sense circuit 110 reads the states of memory cells 106a-106c via signal path 120. Distribution circuit 104 controllably directs read signals between sense circuit 110 and memory cells 106a-106c via signal paths 118a-118c. In one embodiment, distribution circuit 104 includes a plurality of transistors that controllably direct read signals between sense circuit 110 and memory cells 106a-106c.

Sense circuit 110 can read each of the two or more states of the phase change material in each of the memory cells 106a-106c. In one embodiment, to read the resistance of the phase change material, sense circuit 110 provides current that flows through the phase change material of a selected cell and sense circuit 110 reads the voltage across the selected cell. In one embodiment, sense circuit 110 provides voltage across the phase change material of a selected cell and sense circuit 110 reads the current that flows through the selected cell. In one embodiment, write circuit 26 provides voltage across the selected cell and sense circuit 110 reads the current that flows through the selected cell. In one embodiment, write circuit 26 provides current through the selected cell and sense circuit 110 reads the voltage across the selected cell.

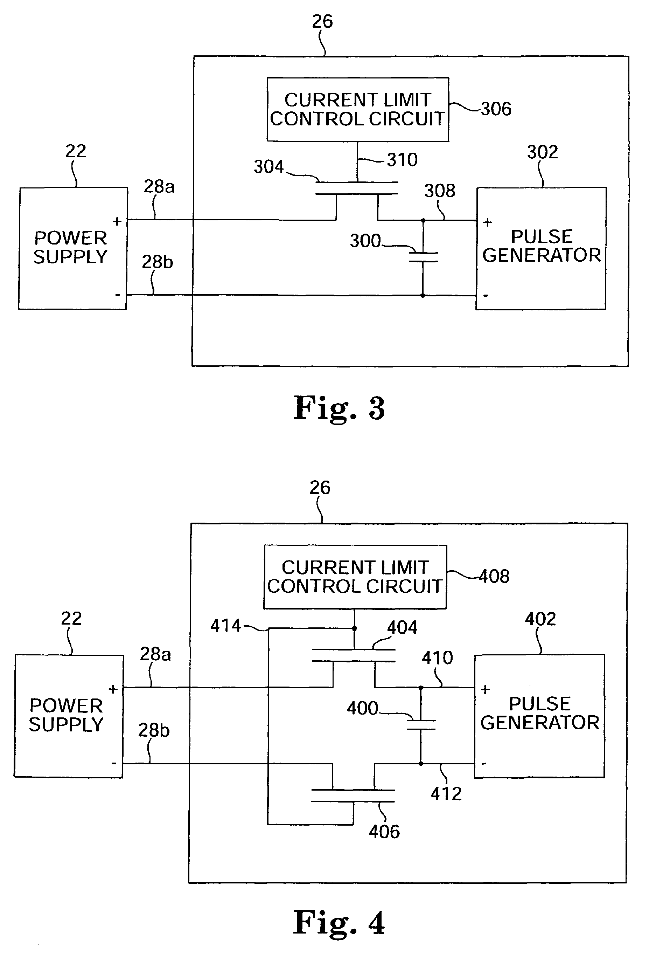

Figure 3 is a diagram illustrating one embodiment of write circuit 26 and power supply 22. Write circuit 26 is electrically coupled to power supply 22 via power supply paths 28a and 28b. Power supply 22 provides power, i.e., voltage and current, to write circuit 26 via power supply paths 28a and 28b. Write circuit 26 receives power from power supply 22 and provides programming pulses to program phase change memory cells. Write circuit 26 limits peak power consumption to stay within the limits of power supply 22.

Write circuit 26 includes a capacitor 300, a pulse generator 302, a switch 304, and a current limit control circuit 306. Switch 304 is a field effect transistor and one side of the drain-source path of switch 304 is electrically coupled to power supply 22 via power supply path 28a. The other side of the drain-source path of switch 304 is electrically coupled to pulse generator 302 and one side of capacitor 300 via current path 308. The gate of switch 304 is electrically coupled to current limit control circuit 306 via gate path 310. The other side of capacitor 300 is electrically coupled to pulse generator 302 and power supply 22 via power supply path 28b. In one embodiment, the field effect transistor is an n-channel metal oxide semiconductor (NMOS) transistor. In one embodiment, the field effect transistor is a p-channel metal oxide semiconductor (PMOS) transistor.

Pulse generator 302 provides programming pulses to the phase change material in the phase change memory cells to program the phase change memory cells. Pulse generator 302 controls current and/or voltage programming pulse amplitudes and durations to program specific states into the phase change memory cells. Pulse generator 302 consumes peak power while programming phase change memory cells, such as while providing a reset pulse to a phase change memory cell.

Write circuit 26 limits the peak power consumption of pulse generator 302 to stay within the limits of power supply 22. In one embodiment, the peak current consumption and the peak power consumption of pulse generator 302 occur while pulse generator 302 resets one or more phase change memory cells. In other embodiments, the peak current consumption and the peak power consumption occur while pulse generator 302 provides any suitable programming pulse(s).

Capacitor 300 is charged via power supply 22 and switch 304. Capacitor 300 provides stored charge to pulse generator 302 in a programming current via current path 308. Switch 304 is operated by current limit control circuit 306 to limit the current drawn from power supply 22 and received by capacitor 300 and pulse generator 302.

Current limit control circuit 306 controls switch 304 to regulate the current drawn from power supply 22 and provided to capacitor 300 and pulse generator 302. If write circuit 26 and pulse generator 302 are inactive, current limit control circuit 306 activates switch 304 to charge capacitor 300. If write circuit 26 and pulse generator 302 are activated to program one or more memory cells, current limit control circuit 306 operates switch 304 to limit the current drawn from power supply 22 and provided to capacitor 300 and pulse generator 302. Capacitor 300 provides stored charge in the programming current to pulse generator 302, which completes programming the memory cell.

In one embodiment, if pulse generator 302 is activated to provide a reset pulse, current limit control circuit 306 turns off switch 304 to limit the current drawn from power supply 22 while the reset pulse is provided via pulse generator 302. In one embodiment, if pulse generator 302 is activated to provide a reset pulse, current limit control circuit 306 biases switch 304 to conduct less current to limit the current drawn from power supply 22 while the reset pulse is provided via pulse generator 302. In one embodiment, if pulse generator is activated to provide one or more set pulses, current limit control circuit 306 turns off switch 304 to limit the current drawn from power supply 22 while the set pulse(s) are provided via pulse generator 302. In one embodiment, if pulse generator is activated to provide one or more set pulses, current limit control circuit 306 biases switch 304 to conduct less current to limit the current drawn from power supply 22 while the set pulse(s) are provided via pulse generator 302.

In operation, current limit control circuit 306 activates switch 304 to charge capacitor 300. Write circuit 26 receives current from power supply 22 and capacitor 300 is charged via switch 304. Next, the memory receives a write command and write circuit 26 is controlled to program one or more phase change memory cells. Current limit control circuit 306 operates switch 304 to limit the current drawn from power supply 22 and provided to capacitor 300 and pulse generator 302. Current limit control circuit 306 and switch 304 limits the current drawn from power supply 22 to stay within limits of power supply 22. Capacitor 300 provides stored charge in the programming current to pulse generator 302. Write circuit 26 completes programming the phase change memory cell while limiting the current drawn from power supply 22. In one embodiment, capacitor 300 and pulse generator 302 receive current from power supply 22 while write circuit 26 completes programming the phase change memory cell. In other embodiments, capacitor 300 and pulse generator 302 do not receive current from power supply 22 while write circuit 26 completes programming the phase change memory cell. After programming is complete, current limit control circuit 306 activates switch 304 to charge capacitor 300.

Figure 4 is a diagram illustrating one embodiment of power supply 22 and a write circuit 26 that includes two switches. Write circuit 26 is electrically coupled to power supply 22 via power supply paths 28a and 28b. Power supply 22 provides power, i.e., voltage and current, to write circuit 26 via power supply paths 28a and 28b. Write circuit 26 receives power from power supply 22 and provides programming pulses to program phase change memory cells. Write circuit 26 limits peak power consumption to stay within the limits of power supply 22.

Write circuit 26 includes a capacitor 400, a pulse generator 402, a first switch 404, a second switch 406, and a current limit control circuit 408. First switch 404 is a field effect transistor and second switch 406 is a field effect transistor. In one embodiment, each of the switches 404 and 406 is an NMOS transistor. In one embodiment, each of the switches 404 and 406 is a PMOS transistor. In one embodiment, one of the switches 404 and 406 is an NMOS transistor and the other is a PMOS transistor.

One side of the drain-source path of first switch 404 is electrically coupled to power supply 22 via power supply path 28a. The other side of the drain-source path of first switch 404 is electrically coupled to pulse generator 402 and one side of capacitor 400 via forward current path 410. One side of the drain-source path of second switch 406 is electrically coupled to power supply 22 via power supply path 28b. The other side of the drain-source path of second switch 406 is electrically coupled to pulse generator 402 and the other side of capacitor 400 via return current path 412. The gate of first switch 404 and the gate of second switch 406 are electrically coupled to current limit control circuit 408 via gate paths 414.

Pulse generator 402 provides programming pulses to the phase change material in the phase change memory cells to program the phase change memory cells. Pulse generator 402 controls current and/or voltage programming pulse amplitudes and durations to program specific states into the phase change memory cells. Pulse generator 402 consumes peak power while programming phase change memory cells, such as while providing a reset pulse to a phase change memory cell.

Write circuit 26 limits the peak power consumption of pulse generator 402 to stay within the limits of power supply 22. In one embodiment, the peak current consumption and the peak power consumption of pulse generator 402 occur while pulse generator 402 resets one or more phase change memory cells. In other embodiments, the peak current consumption and the peak power consumption occur while pulse generator 402 provides any suitable programming pulse(s).

Capacitor 400 is charged via power supply 22 and first and second switches 404 and 406. Capacitor 400 provides stored charge to pulse generator 402 in a programming current via forward current path 410. First switch 404 is operated by current limit control circuit 408 to limit the current drawn from power supply 22 and received by capacitor 400 and pulse generator 402. Second switch 406 is operated by current limit control circuit 408 to limit the return current from pulse generator 402 to power supply 22.

Current limit control circuit 408 controls the first switch 404 to regulate current drawn from power supply 22 and provided to capacitor 400 and pulse generator 402. Current limit control circuit 408 controls the second switch 406 to regulate the current returned from pulse generator 402 to power supply 22.

If write circuit 26 and pulse generator 402 are inactive, current limit control circuit 408 activates first switch 404 and second switch 406 to charge capacitor 400. If write circuit 26 and pulse generator 402 are activated to program one or more memory cells, current limit control circuit 408 operates first switch 404 to limit the current drawn from power supply 22 and provided to capacitor 400 and pulse generator 402. Also, current limit control circuit 408 operates second switch 406 to limit the return current from pulse generator 402 to power supply 22. Capacitor 400 provides stored charge in the programming current to pulse generator 402, which completes programming the memory cell.

In one embodiment, if pulse generator 402 is activated to provide a reset pulse, current limit control circuit 408 turns off first switch 404 to limit the current drawn from power supply 22 and it turns off second switch 406 to limit the return current to power supply 22. In one embodiment, if pulse generator 402 is activated to provide a reset pulse, current limit control circuit 408 biases first switch 404 to conduct less current from power supply 22 and it biases second switch 406 to conduct less return current from pulse generator 402 to power supply 22. In one embodiment, if pulse generator 402 is activated to provide one or more set pulses, current limit control circuit 408 turns off first switch 404 to limit the current drawn from power supply 22 and it turns off second switch 406 to limit the return current to power supply 22. In one embodiment, if pulse generator 402 is activated to provide one or more set pulses, current limit control circuit 408 biases first switch 404 to conduct less current from power supply 22 and it biases second switch 406 to conduct less return current from pulse generator 402 to power supply 22. In other embodiments, current limit control circuit 408 controls first and second switches 404 and 406 to limit forward current drawn and return current in any suitable combination.

In operation, current limit control circuit 408 activates first switch 404 and second switch 406 to charge capacitor 400. Write circuit 26 receives current from power supply 22 and capacitor 400 is charged via first switch 404. Next, the memory receives a write command and write circuit 26 is controlled to program one or more phase change memory cells. Current limit control circuit 408 operates first switch 404 to limit the current drawn from power supply 22 and provided to capacitor 400 and pulse generator 402. Current limit control circuit 408 operates second switch 406 to limit the return current from pulse generator 402 to power supply 22. Current limit control circuit 408 and the first and second switches 404 and 406 limit the current drawn from and provided to power supply 22 to stay within limits of power supply 22. Capacitor 400 provides stored charge in the programming current to pulse generator 402. Write circuit 26 completes programming the phase change memory cell while limiting the current drawn from power supply 22. In one embodiment, capacitor 400 and pulse generator 402 receive current from power supply 22 while write circuit 26 completes programming the phase change memory cell. In other embodiments, capacitor 400 and pulse generator 402 do not receive current from power supply 22 while write circuit 26 completes programming the phase change memory cell. After programming is complete, current limit control circuit 408 activates the first and second switches 404 and 406 to charge capacitor 400.

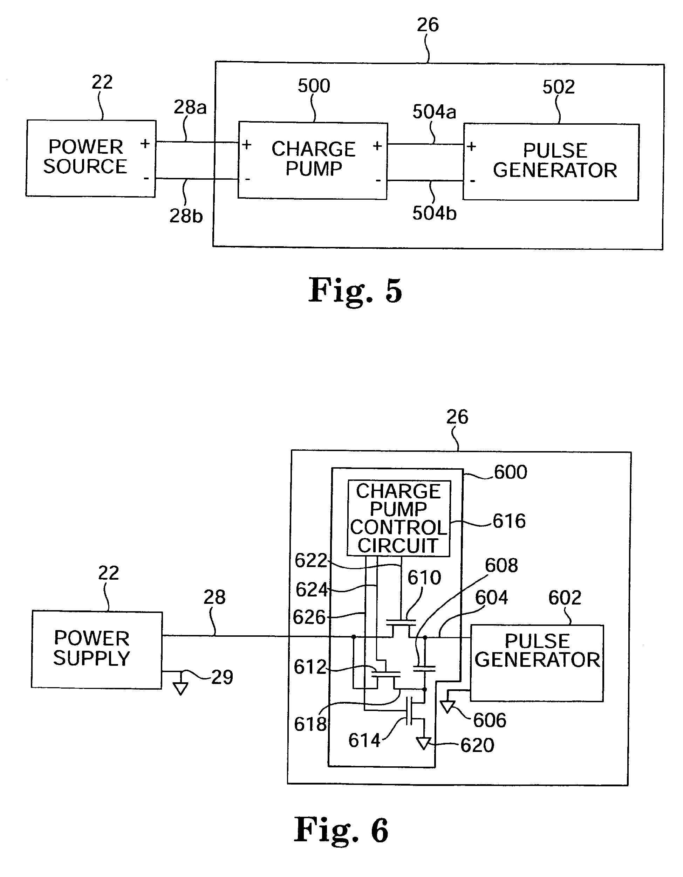

Figure 5 is a diagram illustrating one embodiment of power supply 22 and a write circuit 26 that includes a charge pump 500. Write circuit 26 is electrically coupled to power supply 22 via power supply paths 28a and 28b. Power supply 22 provides power, i.e., voltage and current, to write circuit 26 via power supply paths 28a and 28b. Write circuit 26 receives power from power supply 22 and provides programming pulses to program phase change memory cells. Write circuit 26 limits the peak current drawn by pulse generator 502 from power supply 22 and the peak power consumption drawn from power supply 22 to stay within the limits of power supply 22.

Write circuit 26 includes charge pump 500 and a pulse generator 502. Charge pump 500 is electrically coupled to power supply 22 via power supply paths 28a and 28b. Pulse generator 502 is electrically coupled to charge pump 500 via current paths 504a and 504b.

Pulse generator 502 provides programming pulses to the phase change material in the phase change memory cells to program the phase change memory cells. Pulse generator 502 controls current and/or voltage programming pulse amplitudes and durations to program specific states into the phase change memory cells. Pulse generator 502 consumes peak power while programming phase change memory cells, such as while providing a reset pulse to a phase change memory cell.

Write circuit 26 limits the peak current drawn by pulse generator 502 from power supply 22 and the peak power consumption drawn from power supply 22 to stay within the limits of power supply 22. In one embodiment, the peak current consumption and the peak power consumption of pulse generator 502 occur while pulse generator 502 resets one or more phase change memory cells. In other embodiments, the peak current consumption and the peak power consumption occur while pulse generator 502 provides any suitable programming pulse(s).

Charge pump 500 receives voltage and current from power supply 22 via power supply paths 28a and 28b. Charge pump 500 generates a programming voltage and a programming current that is provided to pulse generator 502. The programming voltage and the programming current are large enough to provide the peak current consumption and the peal power consumption of pulse generator 502. Charge pump 500 provides the programming current to pulse generator 502, which completes programming the memory cell. Charge pump 500 can be any suitable type of charge pump.

In one embodiment, charge pump 500 connects a capacitor across a charging voltage and charges one side of the capacitor to the charging voltage value. The capacitor is disconnected from the charging voltage and the other side of the capacitor is connected to the charging voltage and charged to the charging voltage value, which doubles the voltage on the one side of the capacitor.

Figure 6 is a diagram illustrating one embodiment of power supply 22 and a write circuit 26 that includes a three switch charge pump 600. Write circuit 26 is electrically coupled to power supply 22 via power supply path 28, and power supply 22 is electrically coupled to a reference 29, such as ground. Power supply 22 provides power, i.e., voltage and current, to write circuit 26 via power supply path 28. Write circuit 26 receives power from power supply 22 and provides programming pulses to program phase change memory cells. Write circuit 26 limits the peak current drawn by pulse generator 602 from power supply 22 and write circuit 26 limits the peak power consumption drawn from power supply 22 to stay within the limits of power supply 22.

Write circuit 26 includes charge pump 600 and a pulse generator 602. Charge pump 600 is electrically coupled to power supply 22 via power supply path 28. Pulse generator 602 is electrically coupled to charge pump 600 via programming current path 604, and pulse generator 602 is electrically coupled to a reference 606, such as ground.

In one embodiment, charge pump 600 includes a capacitor 608, a first switch 610, a second switch 612, a third switch 614, and a charge pump control circuit 616. First switch 610 is a field effect transistor, second switch 612 is a field effect transistor, and third switch 614 is a field effect transistor. In one embodiment, each of the switches 610, 612, and 614 is an NMOS transistor. In one embodiment, each of the switches 610, 612, and 614 is a PMOS transistor. In one embodiment, switches 610, 612, and 614 can be any suitable combination of NMOS and PMOS transistors. In other embodiments, first switch 610, second switch 612, and third switch 614 can be any suitable switch types.

One side of the drain-source path of first switch 610 is electrically coupled to one side of the drain-source path of second transistor 612 and to power supply 22 via power supply path 28. The other side of the drain-source path of first switch 610 is electrically coupled to pulse generator 602 and one side of capacitor 608 via programming current path 604. The other side of the drain-source path of second switch 612 is electrically coupled to the other side of capacitor 608 and one side of third transistor 614 via path 618. The other side of the drain-source path of third switch 614 is electrically coupled to a reference 620, such as ground.

Charge pump control circuit 616 is electrically coupled to the gates of first switch 610, second switch 612, and third switch 614. The gate of first switch 610 is electrically coupled to charge pump control circuit 616 via first gate path 622. The gate of second switch 612 is electrically coupled to charge pump control circuit 616 via second gate path 624, and the gate of third switch 614 is electrically coupled to charge pump control circuit 616 via third gate path 626.

Pulse generator 602 provides programming pulses to the phase change material in the phase change memory cells to program the phase change memory cells. Pulse generator 602 controls current and/or voltage pulse amplitudes and durations to program specific states into the phase change memory cells. Pulse generator 602 consumes peak power while programming phase change memory cells, such as while providing a reset pulse to a phase change memory cell.

Write circuit 26 limits the peak current and power drawn from power supply 22 for meeting the peak current and peak power consumption of pulse generator 602. Write circuit 26 limits the peak current and power drawn from power supply 22 to stay within the limits of power supply 22. In one embodiment, the peak current consumption and the peak power consumption of pulse generator 602 occur while pulse generator 602 resets one or more phase change memory cells. In other embodiments, the peak current consumption and the peak power consumption occur while pulse generator 602 provides any suitable programming pulse(s).

Capacitor 608 is charged via power supply 22 and provides stored charge to pulse generator 602 in a programming current via programming current path 604. Charge pump control circuit 616 controls first switch 610 and second switch 612 to limit the current drawn from power supply 22 and the current received by capacitor 608 and pulse generator 602. Charge pump control circuit 616 also controls the third switch to control the voltage value on capacitor 608.

To charge capacitor 608, such as when write circuit 26 and pulse generator 602 are inactive, charge pulse control circuit 616 switches on first switch 610 and third switch 614 and switches off second switch 612. Power supply 22 charges the one side of capacitor 608 to the charging voltage value. Next, charge pulse control circuit 616 switches off first switch 610 and third switch 614 and switches on second switch 612. Power supply 22 charges the other side of capacitor 608 to the charging voltage value, which substantially doubles the voltage value at 604 on the one side of capacitor 608.

If write circuit 26 and pulse generator 602 are activated to program one or more memory cells, charge pump control circuit 616 switches off second switch 612, and capacitor 608 provides stored charge in the programming current to pulse generator 602, which completes programming the memory cell. In other embodiments, charge pump control circuit 616 can leave second switch 612 switched on and capacitor 608 provides stored charge in the programming current to pulse generator 602, which completes programming the memory cell.

In operation, charge pulse control circuit 616 switches on first switch 610 and third switch 614 and switches off second switch 612. Power supply 22 charges the one side of capacitor 608 to the charging voltage value. Next, charge pulse control circuit 616 switches off first switch 610 and third switch 614 and switches on second switch 612. Power supply 22 charges the other side of capacitor 608 to the charging voltage value. This substantially doubles the voltage value at 604 on the one side of capacitor 608.

Next, the memory receives a write command and write circuit 26 is controlled to program one or more phase change memory cells. Charge pump control circuit 616 switches off second switch 612 and maintains first switch 610 and third switch 614 switched off. Capacitor 608 provides stored charge in the programming current to pulse generator 602, which completes programming the memory cell. In one embodiment, after programming is complete, charge pump control circuit 616 controls first switch 610, second switch 612, and third switch 614 to re-charge capacitor 608.

Write circuit 26 completes programming the phase change memory cell while limiting the current drawn from power supply 22. Charge pump control circuit 616 controls first switch 610, second switch 612, and third switch 614 to limit the current drawn from power supply 22 and the current received by capacitor 608 and pulse generator 602 to stay within the limits of power supply 22.

In one embodiment, two or more parallel circuits as shown in Figure 7 are used to increase the write throughput for the memory. Each channel provides power to a part of the memory array where charging and discharging of the capacitor is controlled such that in one cycle channel 1 is charged and all others are discharged or inactive and in the next cycle channel 2 is charged and all others are discharged or inactive. With this scheme the throughput is increased while limiting the maximum power consumption to a single channel's power consumption.

In one embodiment, the scheme described above is used to control the bit-line bias. In another embodiment, the scheme described above is used to control the word-line bias. In another embodiment, the scheme described above is used to control both the word-line and bit-line bias.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A memory, comprising:
resistive memory cells, wherein each of the resistive memory cells is programmable to each of at least two states;
a pulse generator that provides write pulses to program the resistive memory cells; and
a circuit that receives a first current and limits the first current and provides stored charge in a second current to the pulse generator to program the resistive memory cells.

2. The memory of claim 1, wherein the circuit comprises:
a capacitor that provides the stored charge in the second current to the pulse generator.

3. The memory of claim 1, wherein the circuit comprises:
a controller that controls the first current to provide the stored charge in the second current to the pulse generator as the pulse generator resets at least one of the resistive memory cells.

4. The memory of claim 1, wherein the circuit comprises:
a charge pump that receives the first current and provides the stored charge in the second current to the pulse generator.

5. The memory of claim 1, wherein the resistive memory cells comprise phase change memory cells, wherein each of the phase change memory cells includes at least one of Ge, Sb, Te, Ga, As, In, Se, and S.

6. A memory, comprising:
phase change memory cells, wherein each of the phase change memory cells is programmable to each of at least two states;
a pulse generator that provides write pulses to program the phase change memory cells; and
a circuit that receives a first current and limits the first current and provides stored charge in a second current to the pulse generator to program the phase change memory cells.

7. The memory of claim 6, wherein the circuit comprises:
a capacitor that provides the stored charge in the second current to the pulse generator.

8. The memory of claim 6, wherein the circuit comprises:
a controller that controls the first current to provide the stored charge in the second current to the pulse generator as the pulse generator resets at least one of the phase change memory cells.

9. The memory of claim 8, wherein the circuit comprises:
a first switch and the controller operates the first switch to control the first current.

10. The memory of claim 9, wherein the circuit comprises:
a second switch and the controller operates the second switch to control return current from the pulse generator.

11. The memory of claim 8, wherein the circuit comprises:
a first switch;
a second switch; and
a third switch, wherein the controller operates the first switch, the second switch, and the third switch to charge one side of a capacitor to a first voltage value and to charge the other side of the capacitor to a second voltage value that increases the first voltage value on the one side of the capacitor by the second voltage value.

12. The memory of claim 6, wherein the circuit comprises:
a charge pump that receives the first current and provides the stored charge in the second current to the pulse generator.

13. The memory of claim 6, wherein the circuit comprises:
a capacitor; and
a controller that controls the first current to provide the first current to the capacitor and the pulse generator.

14. The memory of claim 6, wherein each of the phase change memory cells includes at least one of Ge, Sb, Te, Ga, As, In, Se, and S.

15. A memory system, comprising:
phase change memory cells, wherein each of the phase change memory cells is programmable to each of at least two states;
a pulse generator that provides write pulses to program the phase change memory cells;
a capacitor; and
a control circuit that limits current received from a power source to the capacitor as the pulse generator resets at least one of the phase change memory cells.

16. The memory system of claim 15, wherein the capacitor provides stored charge to the pulse generator as the pulse generator resets at least one of the phase change memory cells.

17. The memory system of claim 15, comprising:
a first switch, wherein the control circuit operates the first switch to limit the current to the capacitor and to charge one side of the capacitor.

18. The memory system of claim 17, comprising:
a second switch, wherein the control circuit operates the second switch to regulate return current from the pulse generator.

19. The memory system of claim 17, comprising:
a second switch, wherein the control circuit operates the second switch to charge the other side of the capacitor.

20. A memory comprising:
phase change memory cells, wherein each of the phase change memory cells is programmable to each of at least two states;
means for programming the phase change memory cells;
means for receiving a first current;
means for limiting the first current as the phase change memory cells are programmed; and
means for providing stored charge in a second current to the means for programming to program the phase change memory cells.

21. The memory of claim 20, wherein the means for limiting the first current comprises:
a first switch; and
means for controlling the first switch to limit the first current.

22. The memory of claim 21, comprising:
a second switch, wherein the means for controlling the first switch operates the second switch to control return current from the means for programming.

23. The memory of claim 21, comprising:
a capacitor; and
a second switch, wherein the means for controlling the first switch operates the first switch to charge one side of the capacitor and operates the second switch.

24. A method for programming memory comprising:
providing phase change memory cells;
receiving a first current;
limiting the first current as the phase change memory cells are programmed; and
providing stored charge in a second current to program the phase change memory cells.

25. The method of claim 24, wherein limiting the first current comprises:
providing a first switch; and
controlling the first switch to limit the first current.

26. The method of claim 25, comprising:
providing a second switch; and
controlling the second switch to control return current from a pulse generator.

27. The method of claim 25, comprising:
providing a capacitor;
providing a second switch;
controlling the first switch to charge one side of the capacitor; and
controlling the second switch to charge the other side of the capacitor.

28. The method of claim 24, wherein providing stored charge comprises:
providing a capacitor;
controlling the first current to charge the capacitor via the first current; and
limiting the first current to the capacitor to provide the stored charge in the second current.

29. A method for programming memory comprising:
providing phase change memory cells;
providing a capacitor;
programming the phase change memory cells; and
limiting current received from a power source to the capacitor as the phase change memory cells are programmed.

30. The method of claim 29, comprising:
providing stored charge to a pulse generator as the pulse generator resets at least one of the phase change memory cells.
